# EUROPÄISCHE PATENTSCHRIFT

(11) **EP 2 095 138 B1**
(45) Veröffentlichungstag und Bekanntmachung des Hinweises auf die Patenterteilung: **16.08.2017**
(21) Anmeldenummer: 07819330.7
(22) Anmeldetag: 25.10.2007
(51) Int. Cl.: G01R 23/18, G01R 13/02

(54) **VERFAHREN UND VORRICHTUNG ZUR ERMITTLUNG EINER STATISTISCHEN MESSKENNGRÖSSE**
METHOD AND DEVICE FOR THE DETERMINATION OF A STATISTICAL MEASUREMENT VALUE
PROCÉDÉ ET DISPOSITIF DE DÉTERMINATION D'UN PARAMÈTRE DE MESURE STATISTIQUE

(30) Priorität: 28.11.2006 DE 102006056154
(43) Veröffentlichungstag der Anmeldung: 02.09.2009
(73) Patentinhaber: Rohde & Schwarz GmbH & Co. KG, 81671 München (DE)
(72) Erfinder: SCHMIDT, Kurt, 85567 Grafing (DE)
(74) Vertreter: Körfer, Thomas
(86) Internationale Anmeldenummer: PCT/EP2007/009282
(87) Internationale Veröffentlichungsnummer: WO 2008/064752

(56) Entgegenhaltungen:
- EP-A- 0 822 416
- EP-A1- 0 962 778
- WO-A-97/44677
- WO-A-2007/056677
- DE-A1-102006 005 595
- GB-A- 2 207 517
- US-A1- 2004 008 160
- US-A1- 2006 025 947

## Beschreibung

Die Erfindung betrifft ein Verfahren und eine Vorrichtung zur Ermittlung einer statistischen Messkenngröße für alle in mehreren Beobachtungsintervallen jeweils erfassten Häufigkeiten einer Häufigkeitsverteilung von Signalpegeln eines Mess-Signals.

Messgeräte und -systeme bieten oft die Darstellung von Signalpegel-Verteilungen eines zu messenden Signals über der Frequenz oder über der Zeit an. Hierzu wird in einem bestimmten Zeitraster ermittelt, ob jeweils ein Signalpegel des zu messenden Signals im jeweiligen Signalpegelbereich und zum jeweiligen Wert des Zeit- oder Frequenzraster vorliegt. Bei Vorliegen eines Signalpegels des Messsignals wird ein zum jeweiligen Signalpegelbereich und zum jeweiligen Wert des Zeit- oder Frequenzraster gehöriger Zähler inkrementiert. Am Ende des Beobachtungsintervalls werden die Zählerstände aller Zähler ausgelesen und der Anzeige-Einrichtung zu Aktualisierung der Darstellung zugeführt.

Eine solche Darstellung wird z. B. für Realtime-SpektrumAnalysatoren benötigt, die z. B. aus der US 5,103,402 bekannt sind.

Die US 2006/0025947 A1 offenbart eine so genannte Spektrogramm-Triggerung. Hierzu werden die Frequenzspektren zu jeweils aufeinanderfolgenden Signalabschnitten eines Mess-Signals - so genanntes Spektrogramm - mit einer Spektrogramm-Maske, welche sich aus einzelnen Frequenz-Masken für die einzelnen Frequenzspektren in den einzelnen Signalabschnitten des Mess-Signals zusammensetzt, auf Über- oder Unterschreitung verglichen. Im Fall einer positiven Triggerung - Spektralwerte des erfassten Spektrogramms befinden sich alle innerhalb des von der Spektrogramm-Maske vorgegebenen Bereichs - oder im Fall einer negativen Triggerung - Spektralwerte des erfassten Spektrogramms überschreiten die durch die Spektrogramm-Maske vorgegebenen oberen oder unteren Schwellenwerte - wird eine Triggerung aktiviert.

In der GB 2 207 517 A1 werden die vom Spektrumanalysator ermittelten Spektralwerte eines zu vermessenden Signals einer Akquisitions-Einheit zur Analog-Digital-Wandlung, einer Akkumulationseinheit zur Ermittlung von Häufigkeiten der Spektralpegel des zu vermessenden Signals in einzelnen Spektralpegelbereichen zu einzelnen Frequenz-Rasterpunkten und schließlich einer Display-Einheit zur Darstellung der Häufigkeiten der Spektralpegelwerte des zu vermessenden Signals in einzelnen Spektralpegelbereichen zu einzelnen Frequenz-Rasterpunkten zugeführt.

Das in der WO 97/44677 A1 offenbarte digitale Oszilloskop ermittelt in einer "Accumulation-Persistance-Map-Generation"-Einheit die Häufigkeiten der Signalpegel des darzustellenden digitalisierten Signals in einzelnen Signalpegelbereichen und zu einzelnen Zeit-Rasterpunkten einer Häufigkeitsverteilung. Das "Max-Population-Register" ermittelt die maximale Häufigkeit aus allen zu jedem Signalbereich und jedem Zeitrasterpunkt jeweils ermittelten Häufigkeiten der Häufigkeitsverteilung und dient dazu, dem Signalpegel-Zeit-Rasterbereich des Displays mit der höchsten Häufigkeit die hellste Helligkeit zuzuweisen.

Die Ermittlung von Häufigkeiten von Signalpegeln eines darzustellenden Signals in einzelnen Signalpegelbereichen und zu einzelnen Zeit-Rasterpunkten einer Häufigkeitsverteilung auf einem Raster-Display geht auch aus der EP 0 822 416 A2 hervor.

Aus der EP 0 962 778 A1 ist es bekannt, die jeweils ermittelten Häufigkeiten derart zu ersetzen, dass seltener getroffene Rasterpunkte weniger schnell gelöscht werden als häufiger getroffene Rasterpunkte.

Weiterer Stand der Technik ergibt sich aus der WO 2007/056677 A2, der DE 10 2006 005 595 A1 und der US 2004/0008160 A1.

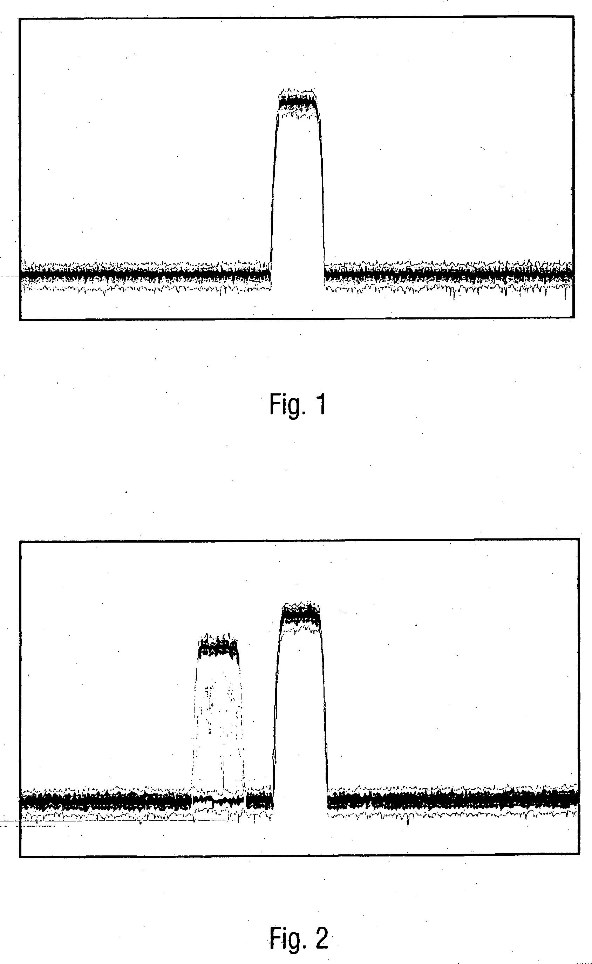

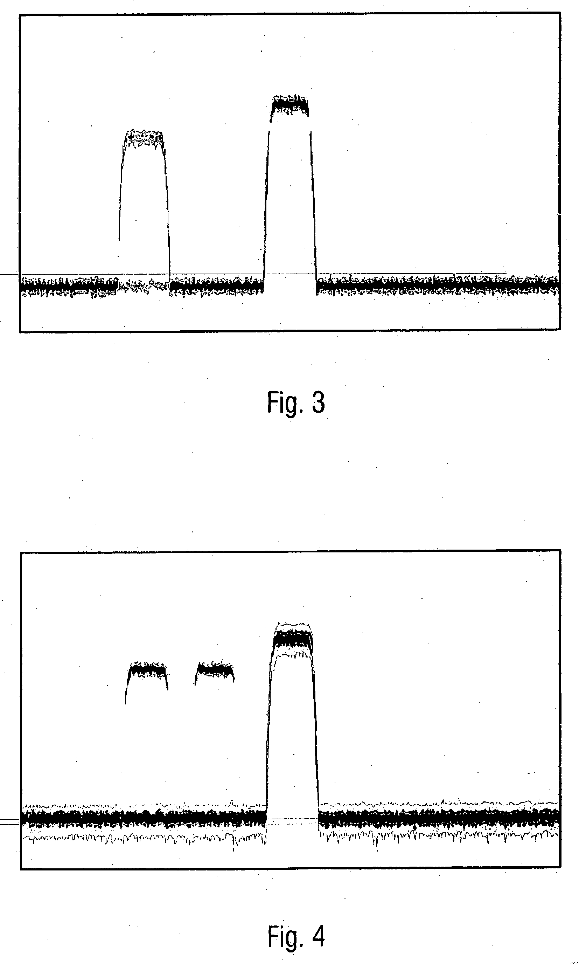

Die kontinuierliche Aktualisierung der Anzeige-Einrichtung mit der aktuellen Häufigkeitsverteilung der erfassten Signalpegel des Mess-Signals über der Zeit oder Frequenz ermöglicht nur die Darstellung der aktuellen Häufigkeitsverteilung - Kurzzeitverhalten - des im allgemeinen stochastischen Mess-Signals. Dies geht aus den Figuren 1, 2 und 3 der Zeichnung hervor, die jeweils die Spektralverteilung eines Mess-Signals zu unterschiedlichen Zeitpunkten darstellen, wobei die Häufigkeit der erfassten frequenzabhängigen Signalpegel des Mess-Signals einer spezifischen Farbe oder entsprechend Fig. 1, 2 und 3 einer spezifischen Graustufe entspricht. In Fig. 1 ist die Spektralverteilung eines Bandpasssignals in einem stetig aktiven Hauptkanal dargestellt. In den Figuren 2 und 3 ist zusätzlich zur Spektralverteilung des Bandpasssignals im stetig aktiven Hauptkanal die Spektralverteilung des Bandpasssignals in jeweils einem nur kurzzeitig aktiven Nebenkanal dargestellt. Man erkennt, dass die Signalinformationen zur Spektralverteilung des Bandpasssignals in den nur kurzzeitig aktiven Nebenkanälen nur über die Zeitdauer des jeweils aktiven Nebenkanals auf dem Display der Anzeige-Einrichtung dargestellt wird und anschließend nachteilig verloren geht.

Die Gewinnung einer Signalinformation des stochastischen Mess-Signals über einen längeren Zeithorizont - Langzeitverhalten - , bei der auch kurzzeitig aktive Signalanteile eingehen und nicht verloren gehen, kann mit einer derartigen den Stand der Technik repräsentierenden Ermittelung und Darstellung der Häufigkeitsverteilung der Signalpegel eines Messsignals nicht realisiert werden.

Aufgabe der Erfindung ist es deshalb, ein Verfahren und eine Vorrichtung zur Ermittlung und Darstellung des Langzeitverhaltens der Häufigkeitsverteilung von Signalpegeln eines stochastischen Mess-Signals über einem Zeit- oder Frequenzraster mit der Berücksichtigung von kurzzeitig aktiven Signälanteilen zu schaffen.

Die Aufgabe der Erfindung wird durch ein erfindungsgemäßes Verfahren zur Ermittlung einer statistischen Messkenngröße für alle in mehreren Beobachtungsintervallen jeweils erfassten Häufigkeiten einer Häufigkeitsverteilung von Signalpegeln eines Mess-Signals mit den Merkmalen des Anspruchs 1 und durch eine erfindungsgemäße Vorrichtung zur Ermittlung einer statistischen Messkenngröße für alle in mehreren Beobachtungsintervallen jeweils erfassten Häufigkeiten einer Häufigkeitsverteilung von Signalpegeln eines Mess-Signals mit den Merkmalen des Anspruchs 4 gelöst. Vorteilhafte Weiterbildungen des erfindungsgemäßen Verfahrens und der erfindungsgemäßen Vorrichtung sind in den abhängigen Ansprüchen aufgeführt.

Erfindungsgemäß wird nach jedem Beobachtungsintervall für jeden Signalpegelbereich und jeden Wert des Zeit- oder Frequenzrasters der Wahrscheinlichkeitsverteilung die jeweils ermittelte Häufigkeit der erfassten Signalpegel des Mess-Signals mit den in allen früheren Beobachtungsintervallen für denselben Signalpegelbereich und denselben Wert des Zeit- oder Frequenzrasters jeweils ermittelten Häufigkeiten der erfassten Signalpegel des Mess-Signals im Hinblick auf die Ermittlung einer statistischen Größe für den jeweiligen Signalpegelbereich und für den jeweiligen Wert des Zeit- oder Frequenzraster der Wahrscheinlichkeitsverteilung ausgewertet.

Bei der statistischen Messkenngröße handelt es sich um den Maximalwert oder den.Mittelwert der in den einzelnen Beobachtungsintervallen jeweils ermittelten Häufigkeiten der Häufigkeitsverteilung oder um andere statistische Kenngrößen handeln, die das Langzeitverhalten der zu den einzelnen Signalpegelbereichen und den einzelnen Werten des Zeit- oder Frequenzrasters gehörigen Häufigkeiten der Häufigkeitsverteilung der erfassten Signalpegel des Mess-Signals charakterisieren.

Für den Fall, dass in einem Beobachtungsintervall für einen Signalpegelbereich und für einen Wert des Zeit- oder Frequenzrasters der Häufigkeitsverteilung der erfassten Signalpegel des Mess-Signals kein Häufigkeitswert ermittelt wird, wird erfindungsgemäß auf dem Display der Anzeige-Einrichtung anstelle einer Nichtaktivierung des für den jeweiligen Signalpegelbereich und für den jeweiligen Wert des Zeit- oder Frequenzraster bestimmten Pixels der Wert der aktuell für den jeweiligen Signalpegelbereich und für den jeweiligen Wert des Zeit- oder Frequenzrasters ermittelten statistischen Kenngröße dargestellt.

Zur Unterscheidung der Darstellung einer aktuell ermittelten statistischen Größe von einer aktuell ermittelten Häufigkeit dient eine unterschiedliche Helligkeit. Da die jeweilige statistische Größe im allgemeinen seltener als die jeweilige Häufigkeit ermittelt wird, wird die statistische Größe auf dem Display der Anzeige-Einrichtung bevorzugt in einer helleren Helligkeit als der jeweilige Häufigkeitswert dargestellt.

Ein Ausführungsbeispiel des erfindungsgemäßen Verfahrens und die erfindungsgemäße Vorrichtung zur Ermittlung einer statistischen Kenngröße für alle in mehreren Beobachtungsintervallen jeweils erfassten Häufigkeiten einer Häufigkeitsverteilung von Signalpegeln eines Mess-Signals werden im folgenden anhand der Zeichnung im Detail erläutert. Die Figuren der Zeichnung zeigen:
- Fig. 1: eine Zeit- oder Spektral-Darstellung der Häufigkeit von Signalpegeln eines Mess-Signals,
- Fig. 2: eine Spektral-Darstellung der Häufigkeit von Signalpegelwerten eines ersten beispielhaften Mess-Signals innerhalb des aktuellen Beobachtungsintervalls,
- Fig. 3: eine Spektral-Darstellung der Häufigkeit von Signalpegelwerten eines ersten beispielhaften Mess-Signals innerhalb des aktuellen Beobachtüngsintervalls,
- Fig. 4: eine Spektral-Darstellung der Häufigkeit von Signalpegelwerten eines ersten beispielhaften Mess-Signals oder der statistischen Kenngröße über Häufigkeiten von Signalpegelwerten eines Mess-Signals nach dem Verfahren und der Vorrichtung,
- Fig. 5: eine Spektral-Darstellung der Häufigkeit von Signalpegelwerten eines zweiten beispielhaften Mess-Signals innerhalb des aktuellen Beobachtungsintervalls,
- Fig. 6: eine Spektral-Darstellung der Häufigkeit von Signalpegeln eines zweiten beispielhaften Mess-Signals innerhalb des aktuellen Beobachtungsintervalls,
- Fig. 7: eine Spektral-Darstellung der Häufigkeit von Signalpegelwerten eines zweiten beispielhaften Mess-Signals oder der statistischen Kenngröße über Häufigkeiten von Signalpegelwerten eines Mess-Signals nach dem Verfahren und der Vorrichtung,
- Fig. 8: eine zweidimensionale Matrix mit unterschiedlichen Graustufen und unterschiedlichen Mustern bzw. Farben zur Darstellung von vierdimensionalen Größen auf einem Display einer Anzeige-Einrichtung,
- Fig. 9: ein Flussdiagramm des Verfahrens zur Ermittlung einer statistischen Kenngröße für alle in mehreren Beobachtungsintervallen jeweils erfassten Häufigkeiten einer Häufigkeitsverteilung von Signalpegeln eines Mess-Signals und
- Fig. 10: ein Blockdiagramm der Vorrichtung zur Ermittlung einer statistischen Kenngröße für alle in mehreren Beobachtungsintervallen jeweils erfassten Häufigkeiten einer Häufigkeitsverteilung von Signalpegeln eines Mess-Signals.

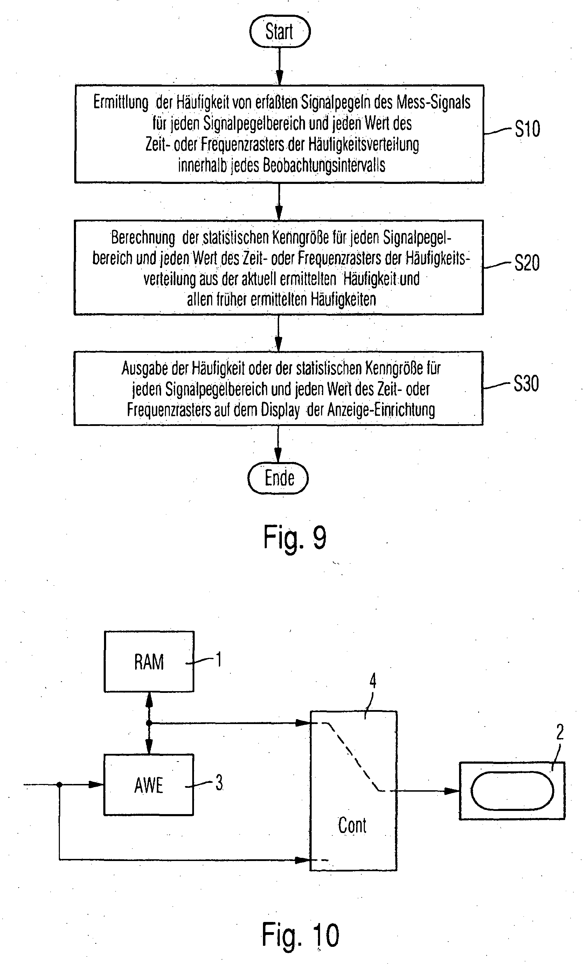

Im Folgenden wird das Verfahren zur Ermittlung einer statistischen Kenngröße für alle in mehreren Beobachtungsintervallen jeweils erfassten Häufigkeiten einer Häufigkeitsverteilung von Signalpegeln eines Mess-Signals anhand von Fig. 9 beschrieben.

Im ersten Verfahrenschritt S10 wird im Zyklus der einzelnen Beobachtungsintervalle die Häufigkeit der im jeweiligen Beobachtungsintervall erfassten Signalpegel des Mess-Signals in den einzelnen Signalpegelbereichen und zu den einzelnen Werten des Zeit- oder Frequenzrasters der Häufigkeitsverteilung gezählt und in einer zum jeweiligen Signalpegelbereich und zum jeweiligen Wert des Zeit- oder Frequenzraster der Häufigkeitsverteilung und zum jeweiligen Beobachtungsintervall gehörigen Speicherzelle einer Speicher-Einheit 1 zwischengespeichert.

Im nächsten Verfahrenschritt S20 wird für jeden Signalpegelbereich und jeden Wert des Zeit- oder Frequenzrasters der Häufigkeitsverteilung jeweils im Zyklus der einzelnen Beobachtungsintervalle eine statistische Kenngrößeder Maximalwert oder der Mittelwert - aus dem für den jeweiligen Signalpegelbereich und für den jeweiligen Wert des Zeit- oder Frequenzrasters aktuell in Verfahrenschritt S10 jeweils ermittelten und zwischengespeicherten Häufigkeitswert und allen für denselben Signalpegelbereich und für denselben Wert des Zeit- oder Frequenzraster in früheren Beobachtungsintervallen ermittelten und zwischengespeicherten Häufigkeitswerten berechnet und in einer zum jeweiligen Signalpegelbereich und zum jeweiligen Wert des Zeit- oder Frequenzrasters der Häufigkeitsverteilung gehörigen Speicherzelle der Speicher-Einheit 1 zwischengespeichert.

Im darauf folgenden und letzten Verfahrenschritt S30 wird am Ende jedes Beobachtungsintervalls im Falle einer im jeweiligen Beobachtungsintervall ermittelten und von Null verschiedenen Häufigkeit von Signalpegeln des Mess-Signals im jeweiligen Signalpegelbereich und zum jeweiligen Wert des Zeit- oder Frequenzrasters der Häufigkeitsverteilung der jeweilige Häufigkeitswert auf dem Display der Anzeige-Einrichtung 2 mit einer dem Häufigkeitswert entsprechenden Farbe oder Graustufe dargestellt.

Für den Fall, dass am Ende des jeweiligen Beobachtungsintervalls im jeweiligen Signalpegelbereich und zum jeweiligen Wert des Zeit- oder Frequenzrasters der Häufigkeitsverteilung kein Signalpegel des Mess-Signals erfasst wird und damit ein Häufigkeitswert von Null vorliegt, wird an Stelle des Häufigkeitswerts die zwischengespeicherte und am Ende des jeweiligen Beobachtungsintervalls entsprechend Verfahrenschritt S20 aktualisierte statistische Kenngröße mit einer dem Wert der statistischen Kenngröße entsprechenden Farbe oder Graustufe auf dem Display in der Anzeige-Einrichtung 2 dargestellt.

Der zu einem Signalpegelbereich und zu einem Wert des Zeit- oder Frequenzrasters der Häufigkeitsverteilung gehörige Wert der statistischen Kenngröße wird auf den Display in der Anzeige-Einrichtung 2 solange dargestellt, bis zu demselben Signalpegelbereich und demselben Wert des Zeit- oder Frequenzrasters ein neuer Häufigkeitswert in einem der folgenden Beobachtungsintervalle ermittelt wird und der Wert der statistischen Kenngröße durch den neuen Häufigkeitswert ersetzt wird.

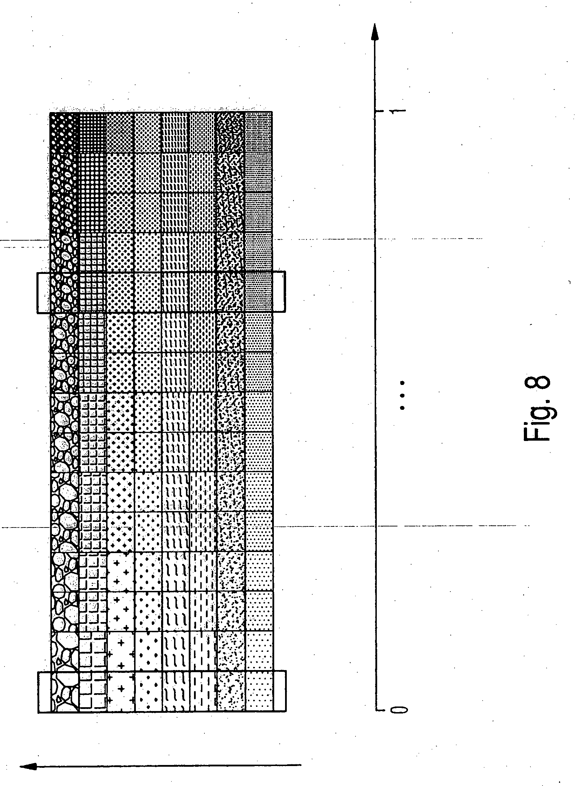

Da in den zu den einzelnen Signalpegelbereichen und zu den einzelnen Werten des Zeit- oder Frequenzrasters der Häufigkeitsverteilung gehörigen Pixeln des Displays der Anzeige-Einrichtung 2 gleichzeitig ein Häufigkeitswert und ein Wert einer statistischen Kenngröße angezeigt werden kann, ist zu deren Unterscheidung die dreidimensionale Signaldarstellung der Spektralverteilung in den Figuren 1, 2 und 3 auf eine vierdimensionale Signaldarstellung zu erweitern. Hierzu wird eine zweidimensionale Matrix gemäß Fig. 8 benutzt, die in Abszissen-Richtung unterschiedliche Graustufen und in Ordinaten-Richtung unterschiedliche Muster oder alternativ zur Darstellung in Fig. 8 unterschiedliche Farbstufen aufweist. In der Praxis werden sich unterschiedliche Farbstufen eher eignen als unterschiedliche Muster, was im Rahmen dieser Patentanmeldung aber nicht darstellbar ist. Für die Darstellung des Häufigkeitswerts oder des Werts der statistischen Kenngröße wird eine dem Häufigkeitswert oder dem Wert der statistischen Kenngröße zugeordnete Farbstufe oder ein dem Häufigkeitswert oder dem Wert der statistischen Kenngröße entsprechend Fig. 8 zugeordnetes Muster benutzt, während für die Klassifizierung eines Häufigkeitswerts eine dunklere Farbstufe oder eine der rechtsseitigen Umrahmung von in Fig. 8 vertikal angeordneten Matrixelementen entsprechende dunklere Graustufe und für die Klassifizierung einer statistischen Kenngröße eine hellere Farbstufe oder eine der linksseitigen Umrahmung von in Fig. 8 vertikal angeordneten Matrixelementen entsprechende hellere Graustufe verwendet wird.

Durch die Benutzung unterschiedlicher Helligkeitsstufen wird eine Priorisierung der einzelnen Darstellungsgrößen auf dem Display verwirklicht. Die Darstellung der vergleichsweise nur sporadisch aktualisierten statistischen Kenngrößen in einem helleren Ton drängt die statistischen Kenngrößen gegenüber den vergleichsweise öfter aktualisierten Häufigkeitswerten, deren Häufigkeitswerte in einem dunkleren Ton dargestellt werden, in den Hintergrund der Display-Darstellung.

Auf diese Weise ergibt sich gemäß Fig. 4 die Spektralverteilung eines Basisbandsignals in einem stetig aktivierten Hauptkanal - Darstellung der Häufigkeiten der frequenzabhängigen Signalpegel des Mess-Signals in dunkleren Graustufen - und die Spektralverteilung eines Basisbandsignals in zwei nur kurzzeitig aktivierten Nebenkanälen-Darstellung der jeweiligen statistischen Kenngrößen der frequenzabhängigen Signalpegel des Mess-Signals in helleren Graustufen -, die auf der Basis des Verfahrens und der Vorrichtung zur Ermittlung einer statistischen Kenngröße für alle in mehreren Beobachtungsintervallen jeweils erfassten Häufigkeiten einer Häufigkeitsverteilung von Signalpegeln eines Mess-Signals ermittelt wurde.

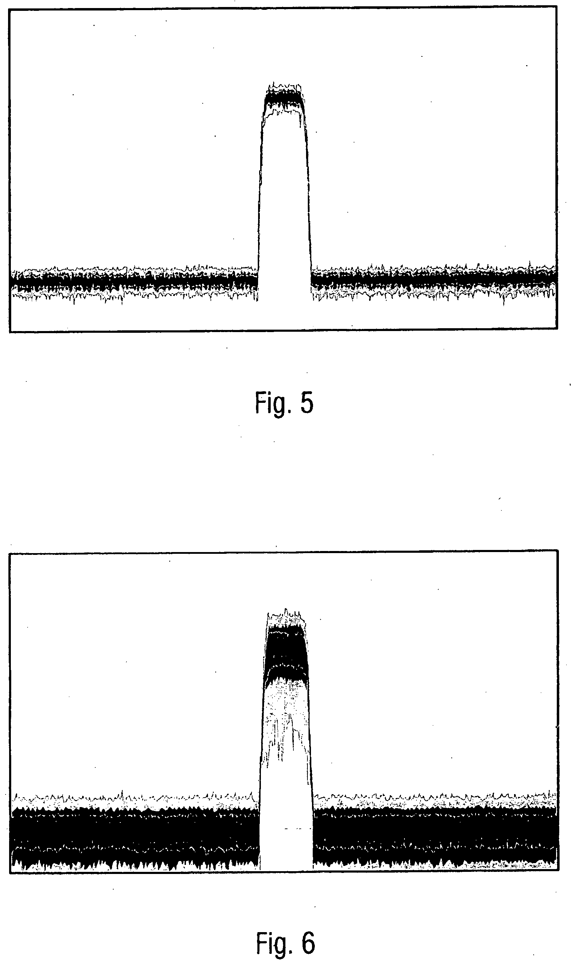

In den Fig. 5 und 6 ist jeweils die spektrale Verteilung eines weiteren Basisbandssignals in einer bisher üblichen Darstellung dargestellt, wobei die in Fig. 5 dargestellten Häufigkeiten der Spektralverteilung auf einer Mittelung über insgesamt ein einziges Beobachtungsintervall basieren, während die in Fig. 6 dargestellten Häufigkeiten der Spektralverteilung über insgesamt 100 Beobachtungsintervalle gemittelt werden. Aufgrund der Mittelung über eine höhere Anzahl von Beobachtungsintervallen weist die Spektralverteilung in Fig. 6 einen "glätteren Verlauf" als die in Fig. 5 dargestellte Spektralverteilung auf.

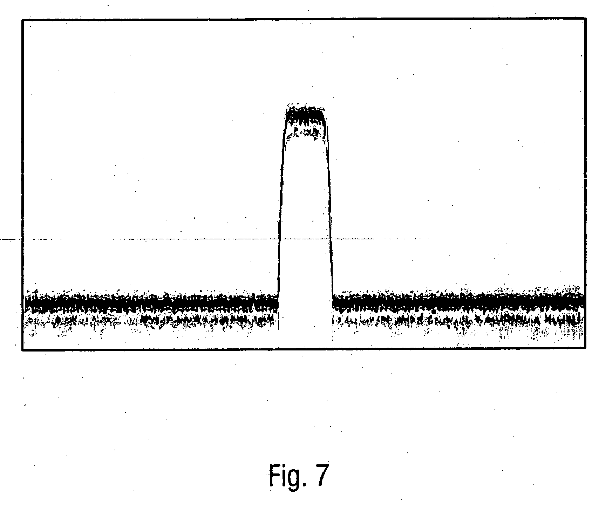

In der nach dem Verfahren und der Vorrichtung ermittelten Spektralverteilung desselben Basisbandsignals der Fig. 7 sind in dunkleren Graustufen die Häufigkeiten der Signalpegel des Mess-Signals, die aus einer Mittelung über insgesamt ein einziges Beobachtungsintervall hervorgehen und somit in jedem Beobachtungsintervall neu ermittelt, zwischengespeichert und dargestellt werden, und in helleren Graustufen die Häufigkeiten des Signalpegel der Signalpegel des Mess-Signals dargestellt, die aus einer Mittelung über insgesamt 100 Beobachtungsintervalle hervorgehen und nur im Zyklen von 100 Beobachtungsintervallen als Häufigkeitswert vorliegen und zwischengespeichert werden und somit nur in die Ermittelung und Darstellung der zugehörigen statistischen Kenngröße eingehen.

Die Vorrichtung zur Ermittlung einer statistischen Kenngröße für alle in mehreren Beobachtungsintervallen jeweils erfassten Häufigkeiten einer Häufigkeitsverteilung von Signalpegeln eines Mess-Signals gemäß Fig. 10 hat eine Speicher-Einheit 1, in der die zu jedem Signalpegelbereich und zu jedem Wert des Zeit- oder Frequenzrasters der Häufigkeitsverteilung und in jedem Beobachtungsintervallen jeweils ermittelte Häufigkeit von Signalpegeln des Mess-Signals und jeweils berechnete statistische Messkenngröße über alle bisher ermittelten Häufigkeiten von Signalpegeln des Mess-Signals abgespeichert ist.

Eine der Speicher-Einheit 1 vorgelagerte AuswertungsEinheit 3 führt einerseits die Speicherung der zu den einzelnen Signalpegelbereichen und zu den einzelnen Werten des Zeit- oder Frequenzraster der Häufigkeitsverteilung gehörigen Häufigkeitswerte und andererseits die Berechnung und Speicherung der für jeden Signalpegelbereich, für jeden Wert des Zeit- oder Frequenzrasters der Häufigkeitsverteilung und für jedes Beobachtungsintervall jeweils zu ermittelnde statistische Messkenngröße durch.

Eine übergeordnete Ablaufsteuerung 4 schaltet bei Vorliegen eines zu einem Signalpegelbereich und zu einem Wert des Zeit- oder Frequenzrasters gehörigen Häufigkeitswerts am Eingang der Auswerte-Einheit 3 den jeweiligen Häufigkeitswert an die Anzeige-Einrichtung 2 zur Darstellung auf dem Display (Anzeigeeinrichtung) und bei Nicht-Vorliegen eines zu einem Signalpegelbereich und zu einem Wert des Zeit- oder Frequenzrasters gehörigen Häufigkeitswerts die zu demselben Signalpegelbereich und zu demselben Wert des Zeit- oder Frequenzrasters gehörigen statistische Kenngröße von der Speicher-Einheit 1 an der Anzeige-Einrichtung 2 zur Darstellung auf den Display durch.

Die Erfindung ist nicht auf die dargestellte Ausführungsform beschränkt. Von der Erfindung sind insbesondere andere vierdimensionale Darstellungsarten - beispielsweise perspektivische dreidimensionale Darstellung zuzüglich einer Farb- oder Graustufen-Darstellung - und andere in den "Hintergrund" der Display-Darstellung gerückte Kenngrößen des Mess-Signals, beispielsweise frequenzabhängiger Signal-Rausch-Abstand, abgedeckt.

## Patentansprüche

1. Verfahren zur Ermittlung einer statistischen Kenngröße für alle in mehreren Beobachtungsintervallen jeweils erfassten Häufigkeiten einer Häufigkeitsverteilung von Signalpegeln eines Mess-Signals und zur Darstellung in einem Zeit und/oder Frequenz-Raster einer Anzeige-Einrichtung (2), mit folgenden Verfahrensschritten:
• Ermitteln von Häufigkeiten von erfassten Signalpegeln des Mess-Signals für jeden Signalpegelbereich und jeden Wert des Rasters der Häufigkeitsverteilung in jedem Beobachtungsintervall durch erneutes Zählen der im jeweiligen Signalpegelbereich und zum jeweiligen Wert des Rasters im jeweiligen Beobachtungsintervall jeweils gemessenen Signalpegel des Mess-Signals in jedem Beobachtungsintervall,
• Zwischenspeichern der ermittelten Häufigkeiten der Häufigkeitsverteilung am Ende jedes Beobachtungsintervalls,
• Ermitteln und erneutes Zwischenspeichern einer statistischen Kenngröße für jeden Signalpegelbereich und jeden Wert des Rasters der Häufigkeitsverteilung am Ende jedes Beobachtungsintervalls aus der für den jeweiligen Signalpegelbereich und für den jeweiligen Wert des Rasters im jeweiligen Beobachtungsintervall ermittelten Häufigkeit und allen für den jeweiligen Signalpegelbereich und für den jeweiligen Wert des Rasters in früheren Beobachtungsintervallen jeweils ermittelten und zwischengespeicherten Häufigkeiten und
• Darstellen der jeweiligen ermittelten statistischen Kenngröße anstelle der jeweiligen ermittelten Häufigkeit auf der Anzeige-Einrichtung (2) für alle Häufigkeiten von Null, falls im jeweiligen Beobachtungsintervall für den jeweiligen Signalpegelbereich und für den jeweiligen Wert des Rasters jeweils eine Häufigkeit von Null ermittelt wird,
wobei die statistische Kenngröße die maximale oder mittlere Häufigkeit von im jeweiligen Signalpegelbereich und im jeweiligen Wert des Rasters der Häufigkeitsverteilung jeweils gemessenen Signalpegeln des Mess-Signals aus in allen Beobachtungsintervallen jeweils gezählten Häufigkeiten von im jeweiligen Signalpegelbereich und im jeweiligen Wert des Rasters der Häufigkeitsverteilung jeweils gemessenen Signalpegeln des Mess-Signals ist.

2. Verfahren nach Anspruch 1,
wobei die zu einem Signalpegelbereich und zu einem Wert des Rasters der Häufigkeitsverteilung zwischengespeicherte statistische Kenngröße auf der Anzeige-Einrichtung (2) in einer anderen Helligkeit als die im jeweiligen Beobachtungsintervall in demselben Signalpegelbereich und in demselben Wert des Rasters des Mess-Signals gezählte Häufigkeit von gemessenen Signalpegeln dargestellt wird.

3. Verfahren nach Anspruch 2,
wobei die zu einem Signalpegelbereich und einem Wert des Rasters des Mess-Signals zwischengespeicherte statistische Kenngröße auf der Anzeige-Einrichtung (2) in einer helleren Helligkeit als die im jeweiligen Beobachtungsintervall in demselben Signalpegelbereich und in demselben Wert des Rasters des Mess-Signals gezählte Häufigkeit von gemessenen Signalpegeln dargestellt wird.

4. Vorrichtung zur Ermittlung einer statistischen Kenngröße für alle in mehreren Beobachtungsintervallen jeweils erfassten Häufigkeiten einer Häufigkeitsverteilung von Signalpegeln eines Mess-Signals und zur Darstellung mit einer Anzeige-Einrichtung (2) zur Darstellung in einem Zeit- und/oder Frequenz-Raster,
einer Speicher-Einheit (1) zur Speicherung einer für jeden Signalpegelbereich und für jeden Wert des Rasters der Häufigkeitsverteilung am Ende jedes Beobachtungsintervalls mittels erneutem Zählen von Signalpegeln des Mess-Signals jeweils ermittelten Häufigkeit und einer statistischen Kenngröße für jeden Signalpegelbereich und für jeden Wert des Rasters der Häufigkeitsverteilung aus der im jeweiligen Beobachtungsintervall und in allen früheren Beobachtungsintervallen für den jeweiligen Signalpegelbereich und für den jeweiligen Wert des Rasters der Häufigkeitsverteilung jeweils ermittelten Häufigkeiten, einer Auswerte-Einheit (3) zur Aktualisierung der jeweiligen in der Speicher-Einheit (1) gespeicherten statistischen Kenngrößen aus den in früheren Beobachtungsintervallen gespeicherten statistischen Kenngrößen und im jeweiligen Beobachtungsintervall jeweils ermittelten Häufigkeiten und
einer übergeordneten Ablaufsteuerung (4) zur Ausgabe der für den jeweiligen Signalpegelbereich und für den jeweiligen Wert des Rasters der Häufigkeitsverteilung in der Speicher-Einheit (1) gespeicherten statistischen Kenngröße anstelle der für denselben Signalpegelbereich und denselben Wert des Rasters jeweils ermittelten Häufigkeit von Signalpegeln des Mess-Signals für alle Häufigkeiten von Null, falls für denselben Signalpegelbereich und denselben Wert des Rasters jeweils keine Signalpegel des Mess-Signals messbar sind,
wobei die statistische Kenngröße die maximale oder mittlere Häufigkeit von im jeweiligen Signalpegelbereich und im jeweiligen Wert des Rasters der Häufigkeitsverteilung jeweils gemessenen Signalpegeln des Mess-Signals aus in allen Beobachtungsintervallen jeweils gezählten Häufigkeiten von im jeweiligen Signalpegelbereich und im jeweiligen Wert des Rasters der Häufigkeitsverteilung jeweils gemessenen Signalpegeln des Mess-Signals ist.

## Claims

1. Method for determining a statistical measurement parameter for all frequencies of occurrence of a frequency of occurrence distribution of signal levels of a test signal registered in each case in several observation intervals, and for displaying in a time and/or frequency raster of a display device (2), having the following method steps:
• determining frequencies of occurrence of registered signal levels of the test signal for each signal-level range and each value of the raster of the frequency of occurrence distribution in each observation interval by re-counting of the signal level, measured in the respective signal-level range and at the respective value of the raster in the respective observation interval, of the test signal in each observation interval,
• buffering the determined frequencies of occurrence of the frequency of occurrence distribution at the end of each observation interval,
• determining and re-buffering a statistical measurement parameter for each signal-level range and each value of the raster of the frequency of occurrence distribution at the end of each observation interval from the frequency of occurrence determined for the respective signal-level range and for the respective value of the raster in the respective observation interval, and all frequencies of occurrence determined and buffered in each case for the respective signal-level range and for the respective value of the raster in previous observation intervals, and
• displaying the respective determined statistical measurement parameter instead of the respective determined frequency of occurrence on the display device (2) for all frequencies of occurrence of zero, if, in the respective observation interval, a frequency of occurrence of zero is determined in each case for the respective signal-level range and for the respective value of the raster,
wherein the statistical measurement parameter is the maximum or mean frequency of occurrence of signal levels of the test signal measured in each case within the respective signal-level range and at the respective value of the raster of the frequency of occurrence distribution from frequencies of occurrence counted respectively in all observation intervals of signal levels of the test signal measured in each case within the respective signal-level range and at the respective value of the raster of the frequency of occurrence distribution.

2. Method according to claim 1,
wherein the statistical measurement parameter buffered at a signal-level range and at a value of the raster of the frequency of occurrence distribution is displayed on the display device (2) with a different brightness from the frequency of occurrence of measured signal levels counted within the respective observation interval in the same signal-level range and at the same value of the raster of the test signal.

3. Method according to claim 2,
wherein the statistical measurement parameter buffered at a signal-level range and a value of the raster of the test signal is displayed on the display device (2) with a brighter brightness than the frequency of occurrence of measured signal levels counted in the respective observation interval in the same signal-level range and at the same value of the raster of the test signal.

4. Device for determining a statistical measurement parameter for all frequencies of occurrence of a frequency of occurrence distribution of signal levels of a test signal registered in each case in several observation intervals and for display, by means of a display device (2), for display in a time and/or frequency raster, of a memory unit (1) for storing a frequency of occurrence, determined in each case for each signal-level range and for each value of the raster of the frequency of occurrence distribution at the end of each observation interval by re-counting of signal levels of the test signal, and a statistical measurement parameter for each signal-level range and for each value of the raster of the frequency of occurrence distribution from the frequencies of occurrence determined in each case in the respective observation interval and in all previous observation intervals for the respective signal-level range and for the respective value of the raster of the frequency of occurrence distribution, an evaluation unit (3) for updating the respective statistical measurement parameters stored in the memory unit (1) from the statistical measurement parameters stored in earlier observation intervals and frequencies of occurrence determined in each case in the respective observation interval and a superordinate procedural control unit (4) for the output of the statistical measurement parameter stored in the memory unit (1) for the respective signal-level range and for the respective value of the raster of the frequency of occurrence distribution instead of the frequency of occurrence of signal levels of the test signal determined in each case for the same signal-level range and the same value of the raster, for all frequencies of occurrence of zero, if no signal levels of the test signal for the same signal-level range and the same value of the raster are in each case measurable, wherein the statistical measurement parameter is the maximum or mean frequency of occurrence of signal levels of the test signal measured in each case within the respective signal-level range and at the respective value of the raster of the frequency of occurrence distribution from frequencies of occurrence counted respectively in all observation intervals of signal levels of the test signal measured in each case within the respective signal-level range and at the respective value of the raster of the frequency of occurrence distribution.

## Revendications

1. Procédé de détermination d'un paramètre statistique pour toutes les fréquences, saisies respectivement dans plusieurs intervalles d'observation, d'une répartition de fréquences de niveaux de signal d'un signal de mesure et de représentation dans une grille de temps et/ou de fréquence d'un dispositif d'affichage (2), comprenant les étapes de procédé suivantes :
- la détermination de fréquences de niveaux de signal saisis du signal de mesure pour chaque plage de niveaux de signal et chaque valeur de la grille de la répartition de fréquences dans chaque intervalle d'observation par nouveau comptage des niveaux de signal du signal de mesure dans chaque intervalle d'observation mesurés respectivement dans la plage de niveaux de signal respective et par rapport à la valeur respective de la grille dans l'intervalle d'observation respective,
- la mise en mémoire à un stade intermédiaire des fréquences déterminées de la répartition de fréquences à la fin de chaque intervalle d'observation,
- la détermination et la nouvelle mise en mémoire à un stade intermédiaire d'un paramètre statistique pour chaque plage de niveaux de signal et chaque valeur de la grille de la répartition de fréquences à la fin de chaque intervalle d'observation à partir de la fréquence déterminée pour la plage de niveaux de signal respective et pour la valeur respective de la grille dans l'intervalle d'observation respective et de toutes les fréquences mises en mémoire à un stade intermédiaire et déterminées respectivement pour la plage de niveaux de signal respective et pour la valeur respective de la grille dans des intervalles d'observation antérieurs et
- la représentation du paramètre statistique déterminé respectif en lieu et place de la fréquence déterminée respective sur le dispositif d'affichage (2) pour toutes les fréquences de zéro, au cas où, dans l'intervalle d'observation respective, respectivement une fréquence de zéro serait déterminée pour la plage de niveaux de signal respective et pour la valeur respective de la grille,
dans lequel le paramètre statistique est la fréquence maximale ou moyenne des niveaux de signal du signal de mesure mesurés respectivement dans la plage de niveaux de signal respective et dans la valeur respective de la grille de la répartition de fréquences à partir de fréquences, comptées respectivement dans tous les intervalles d'observation, de la plage de niveaux de signal respective et de niveaux de signal du signal de mesure mesurés respectivement dans la valeur respective de la grille de la répartition de fréquences.

2. Procédé selon la revendication 1,
dans lequel le paramètre statistique mis en mémoire à un stade intermédiaire par rapport à une plage de niveaux de signal et à une valeur de la grille de la répartition de fréquences est représenté sur le dispositif d'affichage (2) dans une luminosité différente de celle de la fréquence de niveaux de signal mesurés comptée dans l'intervalle d'observation respectif dans la même plage de niveaux de signal et dans la même valeur de la grille du signal de mesure.

3. Procédé selon la revendication 2,
dans lequel le paramètre statistique mis en mémoire à un stade intermédiaire par rapport à une plage de niveaux de signal et à une valeur de la grille du signal de mesure est représenté sur le dispositif d'affichage (2) dans une luminosité plus claire que celle de la fréquence des niveaux de signal mesurés comptée dans l'intervalle d'observation respectif dans la même plage de niveaux de signal et dans la même valeur de la grille du signal de mesure.

4. Dispositif de détermination d'un paramètre statistique pour toutes les fréquences d'une répartition de fréquences de niveaux de signal d'un signal de mesure saisies respectivement dans plusieurs intervalles d'observation et de représentation au moyen d'un dispositif d'affichage (2) pour la représentation dans une grille de temps et/ou de fréquence,
comprenant une unité de mise en mémoire (1) pour la mise en mémoire d'une fréquence déterminée respectivement pour chaque plage de niveaux de signal et pour chaque valeur de la grille de la répartition de fréquences à la fin de chaque intervalle d'observation par nouveau comptage de niveaux de signal du signal de mesure et d'un paramètre statistique pour chaque plage de niveaux de signal et pour chaque valeur de la grille de la répartition de fréquences à partir des fréquences déterminées respectivement dans l'intervalle d'observation respectif et dans tous les intervalles d'observation antérieurs pour la plage de niveaux de signal respective et pour la valeur respective de la grille de la répartition de fréquences, une unité d'évaluation (3) pour l'actualisation des paramètres statistiques respectifs mis en mémoire dans l'unité de mise en mémoire (1) à partir des paramètres statistiques mis en mémoire dans les intervalles d'observation antérieurs et des fréquences déterminées respectivement dans l'intervalle d'observation respectif et
une commande séquentielle (4) prioritaire destinée à délivrer le paramètre statistique mis en mémoire dans l'unité de mise en mémoire (1) pour la plage de niveaux de signal respective et pour la valeur respective de la grille de la répartition de fréquences en lieu et place de la fréquence de niveaux de signal du signal de mesure déterminée respectivement pour la même plage de niveaux de signal et la même valeur de la grille pour toutes les fréquences de zéro, au cas où respectivement aucun niveau de signal du signal de mesure ne pourrait être mesuré pour la même plage de niveaux de signal et la même valeur de la grille,
dans lequel le paramètre statistique est la fréquence maximale ou minimale de niveaux de signal du signal de mesure mesurés respectivement dans la plage de niveaux de signal respective et dans la valeur respective de la grille de la répartition de fréquences à partir des fréquences comptées respectivement dans tous les intervalles d'observation, de niveaux de signal du signal de mesure mesurés respectivement dans la plage de niveaux de signal respective et dans la valeur respective de la grille de la répartition de fréquences.
